# EUROPEAN PATENT SPECIFICATION

(11) **EP 0 757 382 B1**
(45) Date of publication and mention of the grant of the patent: **28.09.2005**
(21) Application number: 95830343.0
(22) Date of filing: 31.07.1995
(51) Int. Cl.: H01L 29/08, H01L 23/00, H01L 29/06

(54) **High voltage semiconductor monolithic device with integrated edge structure and corresponding manufacturing process**
Monolitische Hochspannungshalbleiteranordnung mit integrierter Randstruktur und Verfahren zur Herstellung
Dispositif monolitique semi-conducteur haute-tension avec une structure de bord intégrée et méthode de fabrication

(43) Date of publication of application: 05.02.1997
(73) Proprietor: STMicroelectronics S.r.l., 20041 Agrate Brianza (Milano) (IT)
(72) Inventor: Leonardi, Salvatore, I-95020 Stazzo-Acireale, Catania (IT); Bolognesi, Davide, I-44011 Argenta, Ferrara (IT)
(74) Representative: Cerbaro, Elena

(56) References cited:
- EP-A- 0 571 027
- GB-A- 2 134 705
- US-A- 4 667 393
- PATENT ABSTRACTS OF JAPAN vol. 015 no. 371 (E-1113) ,18 September 1991 & JP-A-03 147331 (SHINDENGEN ELECTRIC MFG CO LTD) 24 June 1991,
- PATENT ABSTRACTS OF JAPAN vol. 008 no. 036 (E-227) ,16 February 1984 & JP-A-58 192369 (TOKYO SHIBAURA DENKI KK) 9 November 1983,

## Description

The present invention relates to a monolithic high-voltage semiconductor device with integrated edge structure and to an associated manufacturing process.

As known, monolithic high-voltage semiconductor devices comprising type PN planar junctions must withstand high voltages with reverse bias.

A typical example is the base-collector junction of an NPN bipolar transistor.

The larger part of PN junctions provided by planar technology comprise essentially a first semiconductor region, e.g. a diffused region having a first conductivity type which is formed inside a second semiconductor region, e.g. an epitaxial layer having conductivity of opposite type.

Over these two regions is deposited an insulating oxide layer on which are provided the metallic contacts for electrical connection of the junction.

Under conditions of reverse bias the junction is surrounded by a charge depletion region in which is present an electrical field which does not have uniform distribution.

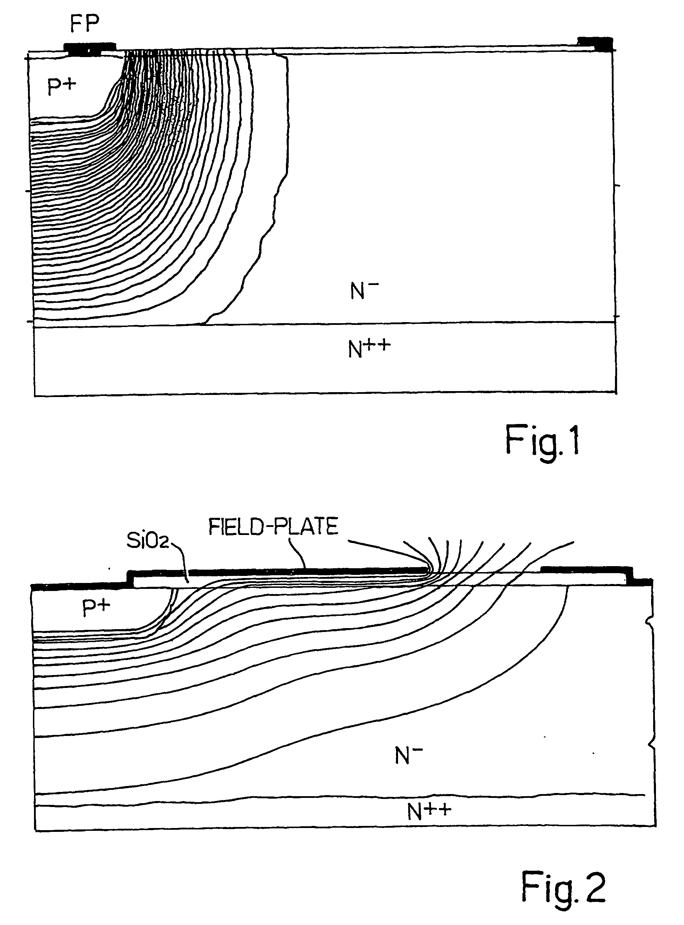

Indeed, as shown in FIG. 1, near the flat portion of the junction the equipotential lines are parallel while near the edge portion of the junction, because of the finite dimensions of the latter, the equipotential lines are curved and are much less spaced apart.

This involves raising of the electrical field especially near the surface of the semiconductor device.

This high surface electrical field causes the breakdown voltage of the junction to be less near the edge portion than at the flat portion.

To reduce the electrical field in the edge portion there are used different known technical solutions.

A common objective of these techniques is essentially that of modifying the dimensions of the depletion region so as to prevent local increases in the electrical field from causing premature junction breakdown.

A first solution of the prior art to satisfy this requirement calls for provision of so-called metallic field plates which are formed by extending the metallic contact of the diffuse regions over the insulation oxide layer as shown in FIG. 2.

The metallic field plate, by acting as a shield, forces the equipotential lines to extend in a wider portion of the semiconductor device to aid reduction of the surface electrical field and consequent increase in the breakdown voltage of the junction edge portion.

Although advantageous in some ways this first technical solution of the prior art exhibits the shortcoming that at the edges of the metallic field plate the shielding action decreases with consequent increase in the surface electrical field.

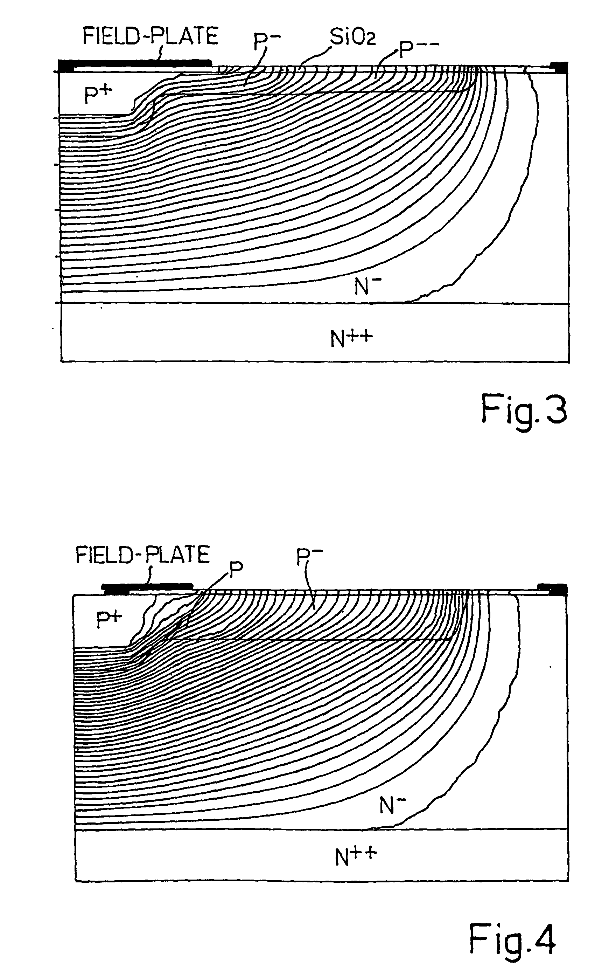

A second solution of the prior art is described in US patent no. 4,667,393 of the same applicant which suggests providing near the junction edge portion an edge structure comprising one or more so-called high-resistivity rings as shown in FIG. 3.

The depletion region is thus extended into a broader portion of the semiconductor device to broaden the space charge distribution with resulting decrease in the surface electrical field.

Specifically the rings are provided inside the epitaxial layer by means of implantation and diffusion of a dopant material having conductivity type opposite that of the epitaxial layer and specifically type P-.

By controlling the amount of implanted material and the diffusion process it is possible to achieve the desired resistivity.

When the semiconductor device must withstand high voltages there are provided two or more concentric rings with resistivity decreasing from the inside outward.

However, small ring junction depth to epitaxial layer thickness ratios are responsible for rather high surface electrical field values hence sensitive to the charges present near the device surface (moving charges and charges located at the interface between the insulating oxide and the silicon).

Local variations in the electrical field due to these charges can generate so-called walk out/walk in phenomena or conduction of channeled charges which overall make the edge structure unsteady and precarious.

As shown in FIG. 4, by increasing the ring junction depth to epitaxial layer thickness ratio there are obtained rings with greater curve radii which improve the uniformity of the depletion region and lower the surface electrical field values.

Thus there is provided another technical solution of the prior art, denominated "deep ring technique", capable of ensuring better stability of the edge structure.

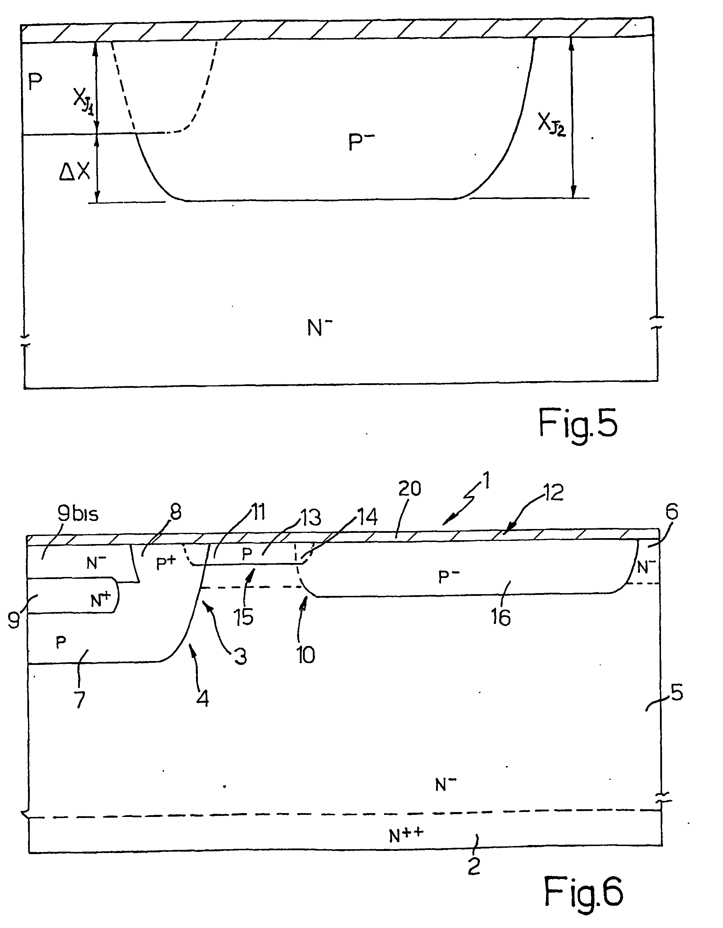

It is noted that this technique is based on the important result that the junction breakdown voltage depends heavily on the quantity ΔX=Xj2-Xj1 where Xj1 is the junction depth for the junction to be protected while Xj2 is the junction depth of a so-called termination region incorporating the rings provided by the above mentioned technique as shown in FIG. 5.

In the presence of termination regions with non-unity edge efficiency, upon increase in the positive quantity ΔX the breakdown voltage of the junction to be protected also increases.

The edge structures provided in this manner have the advantage of making breakdown of the junction to be protected independent of the diffuse region since the breakdown takes place in the termination region.

Provision of termination regions with high junction depth involves the use of fast diffusers or long or high-temperature diffusion cycles in the case of slow diffusers.

This makes the edge structure integration process very costly especially in the case of slow diffusers.

A further known solution described in JP 3147331 refers to a high-breakdown-strength semiconductor device having a substrate 1 of an N-type conductivity. The substrate 1 comprises a third region 8 of a P⁻-type conductivity formed by a diffusion process or the like between first and second regions 2, 3 both having P⁺-type conductivity. An impurity concentration of the third region 8 is made lower than that of the first region 2. The first region 2 acts as an anode region in the case of a diode and as a base region in the case of a transistor and the second region 3 acts as a guard ring.

Another known solution is disclosed in JP 58192369 and refers to high-voltage semiconductor device formed on a single layer substrate that utilizes a guard ring diffusion layer 13 having a higher dopant material concentration than a second region 17 that is formed between the guard ring 13 and another P-type diffusion region 12. The second region 17 has a lower dopant than the guard ring 13.

The technical problem underlying the present invention is to provide a monolithic semiconductor device with integrated edge structure especially efficient and economical to manufacture.

The solution idea underlying the present invention is to place between a junction to be protected and a termination region a thin region of appropriate thickness and doping so as to achieve extension of the junction to be protected while simultaneously reducing its depth.

The technical problem is solved by a device of the type indicated above and defined in the characterizing part of claim 1 annexed hereto. A corresponding method of manufacturing a device is set out in claim 6.

The technical problem is also solved by a process for manufacture of the above mentioned device in accordance with claim 12.

The characteristics and advantages of the device and process in accordance with the present invention are set forth in the description of an embodiment thereof given below by way of non-limiting example with reference to the annexed drawings.

In the drawings:
FIG. 1 shows a vertical cross section in enlarged scale of a planar junction,
FIGS. 2 to 5 show vertical cross sections in enlarged scale of different embodiments in accordance with the prior art of an edge structure associated with the planar junction shown in FIG. 1,
FIG. 6 shows a vertical cross section in enlarged scale of a high-voltage semiconductor device with incorporated edge structure provided in accordance with the present invention,
FIG. 7 shows the device of FIG. 7 with incorporated edge structure represented in a second and more general embodiment in accordance with the present invention, and
FIGS. 8 to 10 show different trends of the equipotential lines inside the device in accordance with the present invention.

With reference to the figures reference number 1 indicates as a whole and schematically a monolithic high-voltage semiconductor device provided in accordance with the present invention with an integrated edge structure.

The device 1 shown in FIG. 6 is achieved starting from a substrate 2 of semiconductor material, e.g. silicon, having a first type of conductivity and in particular type N++ on which are grown a first 5 and a second 6 epitaxial layer having the same type of conductivity and in particular type N-.

The first epitaxial layer 5 has a high resistivity and a considerable thickness to ensure a high breakdown voltage of the device 1.

In addition the device 1 comprises a junction 3 provided through a first diffused region 4 having a second type of conductivity and in particular type P which is formed in the first 5 and second 6 epitaxial layers.

Specifically the first diffused region 4 comprises a first buried region 7 having conductivity of the second type and in particular type P and a deep region 8 having conductivity of the same type and in particular type P+.

The deep region 8 contacts laterally the first buried region 7 connecting it to the surface of the device 1.

It is noted that in the case of VIPower™ high voltage devices (breakdown voltage: 1000V-2000V) the first buried region 7 should have a junction depth around 1/4 to 1/3 the residual thickness of the first epitaxial layer 5 underlying the region.

Inside the first diffuse region 4 is included a second buried region 9 having conductivity of the first type and in particular type N+ which delimits below a portion 9bis of the epitaxial layer 6 designed to received a circuitry operating at low and/or high voltage.

The first diffused region 4 forms an annular insulating region enclosing the second buried region 9 and the portion 9bis of the epitaxial layer 6 to isolate it completely from the rest of the device 1.

Again with reference to FIG. 6 the device 1 also comprises an edge structure 10 provided inside the epitaxial layers 5 and 6 and in part overlying a portion of edge 11 of the junction 3.

This edge structure 10 comprises at least one termination region 12 having conductivity of the second type and in particular type P- and at least one thin region 13 having the same type of conductivity and in particular type P located between the edge portion 11 of the junction 3 and the termination region 12.

Specifically the thin region 13 is provided in the second epitaxial layer 6 and is partly overlaid on the portion 11 of the junction 3 and partly overlaid on a portion 14 of the termination region 12.

In addition this thin region 13 is provided with appropriate thickness and doping to achieve an extension of the junction 3 while reducing its depth at the same time.

The thin region 13 can also be provided with an inconstant and gradually decreasing resistivity as it approaches the termination region 12.

Specifically the thin region 13 must be less deep than the termination region 12 so as to make more significant the difference between the junction depth of the termination region 12 and the junction depth of the outermost region of the junction 3.

The thin region 13 is also capable of decoupling the electrical field created along the edge portion 11 of the junction 3 from the electrical field created along the edge portion 14 of the termination region 12 overlaid on the thin region 13.

This decoupling occurs when the electrical field component parallel to a junction 15 formed by the thin region 13 and the second epitaxial layer 6 reaches virtually null values in the zone of the epitaxial layer 6 underlying the junction 15 for a depth dependent upon the ratio of the dope concentrations present in the thin region 13 to those present in the epitaxial layers 5 and/or 6.

The width of the thin region 13 also depends on the ratio of its dopant concentration to the dopant concentration present in the edge portion 14 of the termination region 12.

From another viewpoint effective decoupling of the electrical field is achieved when the structure of the termination region 12 is fixed and the dose and extension of the thin region 13 are combined in such a manner as to eliminate the critical nature of the gradient of the equipotential lines respectively on the edge portion 14 of the termination region 12 and on the edge portion 11 of the junction 3, whence can derive edge breakdown of the device 1.

For termination regions provided using material with high diffusivity such as e.g. aluminium in this manner and hence very deep the thin region 13 can comprise at least two diffused regions having type P conductivity and formed on the two epitaxial layers 5 and 6 in such a manner as to better protect the junction 3.

If the termination region 12 is provided using a material with lower diffusivity, e.g. boron, the termination region 12 can be formed from two diffused regions 17, 18 which have greater junction depth than the edge portion 11 of the junction 3.

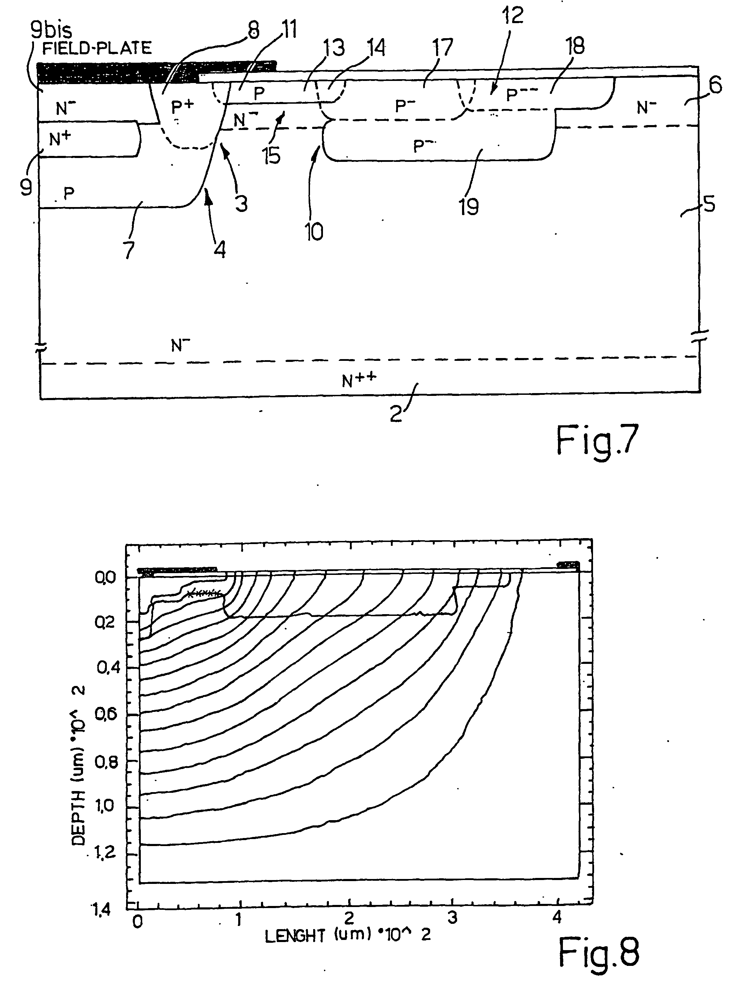

To further increase this junction depth beneath the two diffused regions 17 and 18 there can be provided a third buried region 19 as shown in FIG. 7.

The three regions exhibit high resistivity and conductivity of the second type.

Specifically for the example shown in the figure the diffused region 17 and the third buried region 19 exhibit type P- conductivity while the fifth diffuse region 18 has type P-- conductivity.

Lastly the device 1 comprises a layer of insulating oxide 20 located on the surface on which is provided a metallic region (not shown) for contact of the junction 3 which extends not beyond the portion 11 of the junction.

There are now described the steps of the process leading to production of the device 1.

The integration process begins with growth of the first epitaxial layer 5 on the substrate 2.

In this first epitaxial layer 5 is provided by implantation and successive diffusion heat treatment the first buried region 7.

Successively, it is provided by means of implantation and successive diffusion heat treatment the second diffused region 9 adjoining the first buried region 7.

On the first epitaxial layer 5 is then grown the second epitaxial layer 6 in which is implanted and successively diffused the deep region 8 to permit electrical continuity with the first buried region 7.

The steps thus far described provide for standard production of the diffused and insulated regions typical of VIPower™ devices which use the junction insulation technique for the various components making up the circuitry incorporated in the portion 9bis of the second epitaxial layer 6.

After completion of these steps one proceeds to provision of the edge structure 10.

The thin region 13 which ensures electrical continuity between the junction 3 and the termination region 12 is provided in an intermediate step between formation of the second epitaxial layer 6 and formation of the deep region 8 by means of implantation and successive dedicated diffusion heat treatment.

As an alternative the thin region 13 is formed in successive steps by using implants and heat cycles necessary for provision of the various components making up the circuitry incorporated in the portion 9bis of the second epitaxial layer 6 and hence not explicitly dedicated to provision of the thin region 13.

For provision of the thin region 13 there can also be used variable transparency solutions.

The integration process of the device 1 continues with provision of the termination region 12.

As concerns this region also different process variants are possible.

Specifically if a high-diffusivity dopant material is used the termination region 12 is formed by implantation and successive diffusion heat treatment.

If the material used has lower diffusivity the termination region 12 is formed by implantation and successive diffusion heat treatment of one or more regions, e.g. the two diffused regions 17, 18 so that it is always deeper than the thin region 13 in the part contiguous therewith.

In this regard it is possible to use the same heat treatment used to diffuse the deep region 8 after use of dedicated implantation in the desired regions.

Furthermore if it is desired to improve the overall characteristics of the edge structure 10 there can be achieved e.g. relatively deep diffuse regions using the first epitaxial layer 5.

Indeed, in accordance with the criteria of the prior art, by dedicated implantation and successive diffusion heat treatment to be performed on this first epitaxial layer 5 there can be provided one or more buried regions such as e.g. the third buried region 19.

The only condition to be observed for this purpose is that after completion of the edge structure electrical continuity be assured between the regions integrated respectively on the first and second epitaxial layers (diffused regions 17, 18 and third buried region 19).

For the termination regions of the above described type the known variable transparency technique can be used by appropriately modifying the layouts defining formation of the diffused regions to achieve more elaborate edge structures.

After completion of the termination region 12 the integration process of the device 1 proceeds in accordance with the known integrated power device manufacturing techniques.

In conclusion the device 1 in accordance with the present invention comprises an edge structure 10 which overall exhibits the characteristics called for by integration of termination regions in accordance with the above mentioned known techniques while not necessarily having recourse to integration of termination regions with extremely deep junctions.

An example of an edge structure comprising a termination region provided as in FIG. 7 was simulated by including provision of the thin region 13 in the intermediate step between formation of the second epitaxial layer 6 and formation of the deep region 8.

In figure 8 the junction portion belonging to the thin region 13 is shown with crosses.

In the same figure are also shown the equipotential lines spaced 50V apart, e.g. for the case of a substrate dimensioned for 1500V and biased at this voltage.

It is important to note that near the thin region 13 the equipotential lines remain virtually parallel with the surface of the device 1 while the potential increases mainly beneath the junction 3 to ensure breakdown near its flat portion.

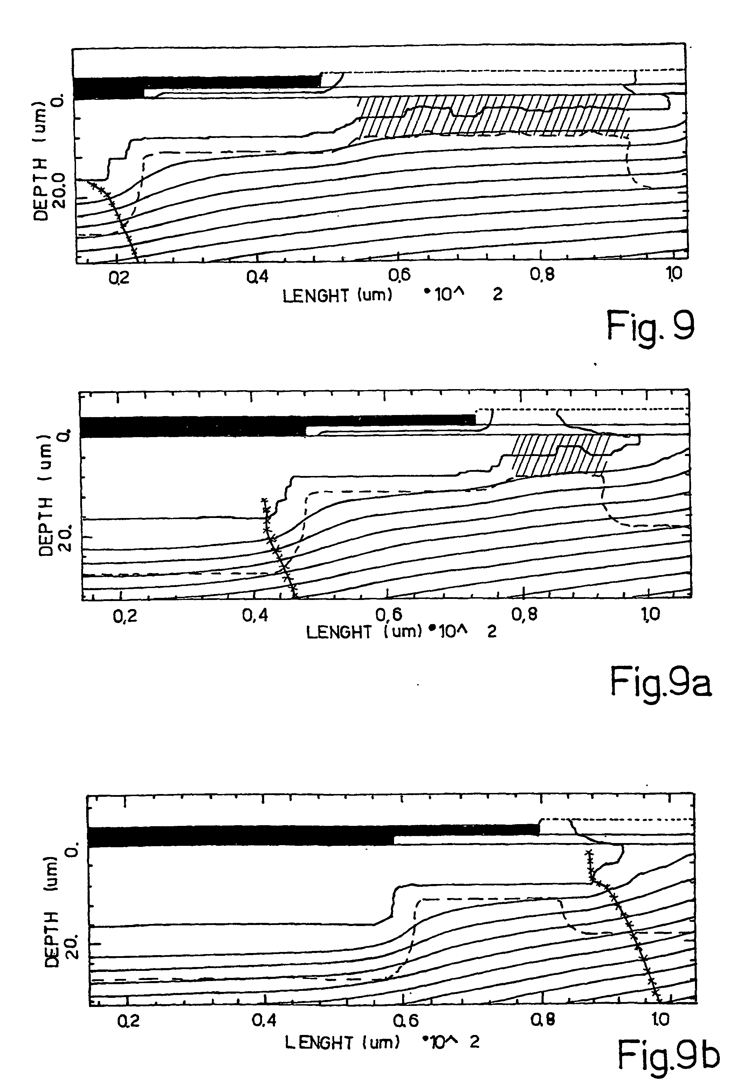

In figures 9 to 9b are reproduced in detail the simulated behaviors of the equipotential lines in the thin region 13, shown with hatching.

The three charts concern the same edge structure in which, from top to bottom, the width of the thin region 13 is different.

In particular, in figure 9b that is not an embodiment of the invention, the third region 13 is absent.

By comparing figs. 9, 9a, 9b it is clear that a shortening of the third region 13 causes the location of the maximum electrical field, as shown by crossed lines, to pass from the corner of the junction 3 to the termination region 12.

Again, since behind the portion 14 of the termination region 12 the electrical field is reduced the depletion region formed outside the junction 3 when it is reverse biased essentially affects the termination region 12 without involving the thin region 13.

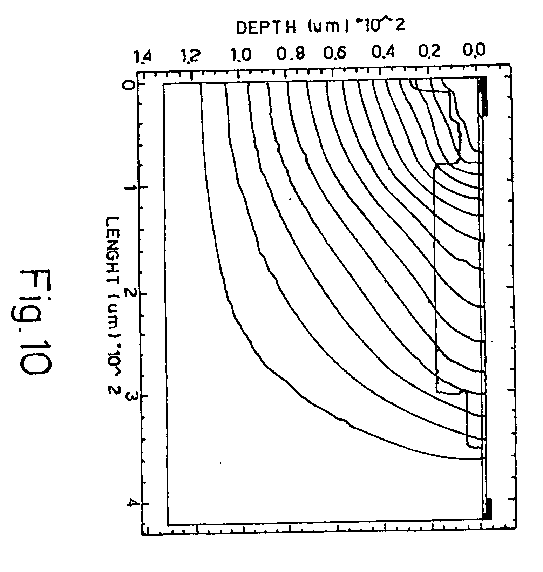

Marginally to these simulations it was also verified that the presence of a metallic field plate has no influence on the behavior of the potential in the thin region 13 as may be inferred by comparison of FIG. 8 with FIG. 10 for an edge structure having a short field plate.

Finally, recourse to the thin region 13 appears to be a valid option because it allows reduction of the overall extension of the termination region 12 while keeping its edge efficiency.

## Claims

1. Monolithic high-voltage semiconductor device with integrated edge structure of the type provided on a substrate (2) having a first conductivity type and on which is grown an epitaxial layer (5, 6) having the same conductivity type of the substrate (2) as well as comprising a first doped region (4) having a second conductivity type provided inside a first portion of the epitaxial layer (5, 6), said first doped region (4) defining a first PN-type junction (3) with said epitaxial layer (5, 6), said first PN-type junction (3) having an edge (11), and an edge structure (10) provided inside a second portion of the epitaxial layer (5, 6) adjacent to the first portion, said edge structure (10) including a termination region (12) formed by a second doped region having the second conductivity type, said termination region (12) defining a second PN-type junction with the epitaxial layer (5, 6), said edge structure (10) further comprising at least one third doped region (13) having the second conductivity type located between the first doped region (4) and the termination region (12) and defining a third PN-type junciton with the epitaxial layer (5, 6) and said third doped region (13) being contiguous with a portion of the edge (11) of the first junction (3) such that it is an extension of said junction (3), **characterized in that** said third junction is shallower than the first and the second junction and has a dopant concentration which is greater than the dopant concentration of the termination region (12).

2. Device in accordance with claim 1 and **characterized in that** the third doped region (13) has a dopant concentration which is lower than the dopant concentration of the first doped region (4).

3. Device in accordance with claim 1 and **characterized in that** the third doped region (13) adjoins the termination region (12).

4. Device in accordance with claim 3 and **characterized in that** the third doped region (13) has an inconstant and gradually decreasing resistivity as it approaches the termination region (12).

5. Device in accordance with claim 4 and **characterized in that** the third doped region (13) has a P-type conductivity.

6. Process for manufacturing a monolithic high-voltage semiconductor device with integrated edge structure of the type provided on a substrate (2) having a first conductivity type and on which is grown an epitaxial layer (5, 6) having the same conductivity type of the substrate (2) as well as comprising a first diffused region (4) having a second conductivity type provided inside a first portion of the epitaxial layer (5, 6), said first diffused region (4) defining a first PN-type junction (3) with said epitaxial layer (5, 6), said first PN-type junction (3) having an edge (11), and an edge structure (10) provided inside a second portion of the epitaxial layer (5, 6) adjacent to the first portion, said edge structure (10) including a termination region (12) formed by a second diffused region having the second conductivity type, said termination region (12) defining a second PN-type junction with the epitaxial layer (5, 6), said process including a step of forming by implantation and successive diffusion at least one third diffused region (13) having the second conductivity type located inside the second portion of the epitaxial layer (5, 6) between the first diffused region (4) and the termination region (12), said third region (13) defining a third PN-type junction with the epitaxial layer (5, 6) which is shallower than the first and the second junction, said third diffused region (13) having a dopant concentration which is greater than the dopant concentration of the termination region (12) and
said third diffused region (13) being contiguous with a portion of the edge (11) of the first junction (3) such that it is an extension of said junction (3).

## Patentansprüche

1. Monolithische Hochspannungshalbleitervorrichtung mit integrierter Randstruktur des Typs, der auf einem Substrat (2) vorgesehen ist, das einen ersten Leitfähigkeitstyp besitzt und auf dem eine epitaktische Schicht (5, 6) mit dem gleichen Leitfähigkeitstyp wie das Substrat (2) aufgewachsen ist und das einen ersten dotierten Bereich (4), der einen zweiten Leitfähigkeitstyp besitzt, in einem ersten Abschnitt der epitaktischen Schicht (5, 6) vorgesehen ist und einen ersten PN-Übergang (3) mit der epitaktischen Schicht (5, 6), der einen Rand (11) besitzt, definiert, und eine Randstruktur (10), die in einem zweiten Abschnitt der epitaktischen Schicht (5, 6) benachbart zu dem ersten Abschnitt vorgesehen ist und einen Abschlussbereich (12) aufweist, der durch einen zweiten dotierten Bereich mit dem zweiten Leitfähigkeitstyp gebildet ist und einen zweiten PN-Übergang mit der epitaktischen Schicht (5, 6) definiert, umfasst, wobei die Randstruktur (10) ferner wenigstens einen dritten dotierten Bereich (13) umfasst, der den zweiten Leitfähigkeitstyp besitzt und sich zwischen dem ersten dotierten Bereich (4) und dem Abschlussbereich (12) befindet und einen dritten PN-Übergang mit der epitaktischen Schicht (5, 6) definiert, wobei der dritte dotierte Bereich (13) zu einem Abschnitt des Randes (11) des ersten Übergangs (3) benachbart ist, so dass er eine Verlängerung des Übergangs (3) bildet, **dadurch gekennzeichnet, dass** der dritte Übergang schlanker als der erste und der zweite Übergang ist und eine Dotierstoffkonzentration besitzt, die größer als die Dotierstoffkonzentration des Abschlussbereichs (12) ist.

2. Vorrichtung nach Anspruch 1, **dadurch gekennzeichnet, dass** der dritte dotierte Bereich (13) eine Dotierstoffkonzentration besitzt, die niedriger als die Dotierstoffkonzentration des ersten dotierten Bereichs (4) ist.

3. Vorrichtung nach Anspruch 1, **dadurch gekennzeichnet, dass** der dritte dotierte Bereich (13) an den Abschlussbereich (12) angrenzt.

4. Vorrichtung nach Anspruch 3, **dadurch gekennzeichnet, dass** der dritte dotierte Bereich (13) bei Annäherung an den Abschlussbereich (12) einen nicht konstanten und allmählich abnehmenden spezifischen elektrischen Widerstand aufweist.

5. Vorrichtung nach Anspruch 4, **dadurch gekennzeichnet, dass** der dritte dotierte Bereich (13) eine P-Leitfähigkeit hat.

6. Verfahren zum Herstellen einer monolithischen Hochspannungshalbleitervorrichtung mit integrierter Randstruktur des Typs, der auf einem Substrat (2) vorgesehen ist, das einen ersten Leitfähigkeitstyp besitzt und auf dem eine epitaktische Schicht (5, 6) mit dem selben Leitfähigkeitstyp wie das Substrat (2) aufgewachsen ist und das einen ersten diffundierten Bereich (4), der einen zweiten Leitfähigkeitstyp besitzt, in einem ersten Abschnitt der epitaktischen Schicht (5, 6) vorgesehen ist und einen ersten PN-Übergang (3) mit der epitaktischen Schicht (5, 6) definiert, der einen Rand (11) besitzt, und eine Randstruktur (10), die in einem zweiten Abschnitt der epitaktischen Schicht (5, 6) benachbart zu dem ersten Abschnitt vorgesehen ist, umfasst, wobei die Randstruktur (10) einen Abschlussbereich (12) aufweist, der durch einen zweiten diffundierten Bereich, der den zweiten Leitfähigkeitstyp besitzt, gebildet ist und einen zweiten PN-Übergang mit der epitaktischen Schicht (5, 6) definiert, wobei das Verfahren einen Schritt umfasst, bei dem durch Implantation und aufeinander folgende Diffusion wenigstens ein dritter diffundierter Bereich (13) gebildet wird, der den zweiten Leitfähigkeitstyp besitzt und sich in dem zweiten Abschnitt der epitaktischen Schicht (5, 6) zwischen dem ersten diffundierten Bereich (4) und dem Abschlussbereich (12) befindet, wobei der dritte Bereich (13) einen dritten PN-Übergang mit der epitaktischen Schicht (5, 6) definiert, der schlanker als der erste und der zweite Übergang ist, wobei der dritte diffundierte Bereich (13) eine Dotierstoffkonzentration besitzt, die größer als die Dotierstoffkonzentration des Abschlussbereichs (12) ist, und wobei der dritte diffundierte Bereich (13) an einen Abschnitt des Randes (11) des ersten Übergangs (3) angrenzt, so dass er eine Verlängerung dieses Übergangs (3) bildet.

## Revendications

1. Dispositif à semi-conducteur monolithique haute tension à structure de bord intégrée du type formé sur un substrat (2) ayant un premier type de conductibilité et sur lequel on a fait croître une couche épitaxiale (5, 6) ayant le même type de conductibilité que le substrat (2) et comprenant une première zone dopée (4) ayant un second type de conductibilité, établie à l'intérieur d'une première partie de la couche épitaxiale (5, 6), ladite première zone dopée (4) définissant une première jonction du type PN(3) avec ladite couche épitaxiale (5, 6), ladite première jonction du type PN(3) ayant un bord (11), et une structure de bord (10) prévue à l'intérieur d'une deuxième partie de la couche épitaxiale (5, 6) adjacente à la première partie, ladite structure de bord (10) comprenant une zone de connexion (12) formée par une deuxième zone dopée possédant le second type de conductibilité, ladite zone de connexion (12) définissant une deuxième jonction du type PN avec la couche épitaxiale (5, 6), ladite structure de bord (10) comportant, en outre, au moins une troisième zone dopée (13) possédant le second type de conductibilité, située entre la première zone dopée (4) et la zone de connexion (12) et définissant une troisième jonction du type PN avec la couche épitaxiale (5, 6), et ladite troisième zone dopée (13) étant contiguë à une partie du bord (11) de la première jonction (3) de telle sorte qu'elle constitue un prolongement de ladite jonction (3), **caractérisé en ce que** ladite troisième jonction est moins profonde que la première et la deuxième jonction, et présente une concentration d'impuretés qui est supérieure à la concentration d'impuretés de la zone de connexion (12).

2. Dispositif selon la revendication 1 et **caractérisé en ce que** la troisième zone dopée (13) présente une concentration d'impuretés qui est inférieure à la concentration d'impuretés de la première zone dopée (4).

3. Dispositif selon la revendication 1 et **caractérisé en ce que** la troisième zone dopée (13) avoisine la zone de connexion (12).

4. Dispositif selon la revendication 3 et **caractérisé en ce que** la troisième zone dopée (13) a une résistivité variable et diminuant progressivement au fur et à mesure qu'elle se rapproche de la zone de connexion (12).

5. Dispositif selon la revendication 4 et **caractérisé en ce que** la troisième zone dopée (13) possède une conductibilité du type P.

6. Procédé de fabrication d'un dispositif à semi-conducteur monolithique haute tension à structure de bord intégrée du type réalisé sur un substrat (2) ayant un premier type de conductibilité et sur lequel on a fait croître une couche épitaxiale (5, 6) ayant le même type de conductibilité que le substrat (2) et comportant une première zone diffusée (4) ayant un second type de conductibilité, établie à l'intérieur d'une première partie de la couche épitaxiale (5, 6), ladite première zone diffusée (4) définissant une première jonction du type PN(3) avec ladite couche épitaxiale (5, 6), ladite première jonction du type PN(3) présentant un bord (11), et une structure de bord (10) prévue à l'intérieur d'une deuxième partie de la couche épitaxiale (5, 6) adjacente à la première partie, ladite structure de bord (10) comprenant une zone de connexion (12) formée par une deuxième zone diffusée possédant le second type de conductibilité, ladite zone de connexion (12) définissant une deuxième jonction du type PN avec la couche épitaxiale (5, 6), ledit procédé comprenant une étape consistant à former, par implantation et diffusion successive, au moins une troisième zone diffusée (13) possédant le second type de conductibilité, située à l'intérieur de la deuxième partie de la couche épitaxiale (5, 6), entre la première zone diffusée (4) et la zone de connexion (12), ladite troisième zone (13) définissant, avec la couche épitaxiale (5, 6), une troisième jonction du type PN, qui est moins profonde que la première et la deuxième jonction, ladite troisième zone diffusée (13) présentant une concentration d'impuretés qui est supérieure à la concentration d'impuretés de la zone de connexion (12) et ladite troisième zone diffusée (13) étant contiguë à une partie du bord (11) de la première jonction (3), de telle sorte qu'elle constitue un prolongement de ladite jonction (3).
